# EUROPEAN PATENT APPLICATION

(11) **EP 4 485 820 A1**
(43) Date of publication of application: **01.01.2025**
(21) Application number: 23182094.5
(22) Date of filing: 28.06.2023
(51) Int. Cl.: H04B 7/185, H04B 17/17

(54) **INTEGRATED CIRCUIT DEVICE FOR A SATELLITE RECEIVER AND SATELLITE RECEIVER SYSTEM**

(71) Applicant: u-blox AG, 8800 Thalwil (CH)
(72) Inventor: MARTIN, Benjamin, 8800 Thalwil (CH); D'ALESSANDRO, Carmine, 8800 Thalwil (CH); DURLER, Marcel, 8800 Thalwil (CH); CHRISTEN, Thomas, 8800 Thalwil (CH); EEROLA, Ville, 8800 Thalwil (CH)
(74) Representative: Epping - Hermann - Fischer

(57) **Abstract**

The present disclosure provides an IC device for a satellite receiver, comprising at least one digital control circuit, at least two general GPIO circuits connected, respectively, with a first connection pin (32) and a second connection pin (34), and an antenna monitoring circuit (54) comprising an ADC circuit (58), wherein a signal input of the an antenna monitoring circuit (54)is connected to the first connection pin (32), and a reference input of the an antenna monitoring circuit (54) is connected to the second connection pin (34). The at least one digital control circuit is configured, in a first mode of operation, to selectively provide an analog signal received via the signal input and the reference input to the ADC circuit (58), to capture a digital value corresponding to the analog signal using the at least one ADC circuit (58), and to compare the captured digital value with at least one programmable threshold value. The at least one digital control circuit is further configured, in a second mode of operation, to disconnect at least parts of the ADC circuit (58) from the first and the second connection pin (32, 34), and to capture or provide a respective digital value from or to at least one of the first pin (32) and the second connection pin (34) using the respective GPIO circuit.

A satellite receiver system (10) is also provided.

## Description

The present disclosure relates to an integrated circuit (IC) device for a satellite receiver comprising at least one control circuit, a plurality of connection pins and at least two general programmable input/output (GPIO) circuits connected with the plurality of connection pins. The disclosure further relates to a satellite receiver system comprising at least one active antenna, a power source, a sense resistor and an IC device.

Circuits for receiving signals from a satellite transmitter are widely known and are used in many different application areas. One particular application area is the use of satellite communication in global navigation satellite systems (GNSS). In this, as well as in other satellite receiver circuits, a received signal strength is often low. Moreover, the actual receiver circuit, typically integrated into a chip to form an IC device, is often placed at a different location than the actual antenna, i.e. the receiver circuit is connected with an external antenna.

To prevent additional signal losses caused by the transmission of the received satellite signal from the antenna via an antenna cable to the receiver circuit, active antennas are often used for signal reception. In this case, a supply current for the active antenna may be provided via the antenna cable to the active antenna. To protect the receiver signal, which is also connected to the antenna cable, it may be desirable to check the antenna cable for faults, in particular for short circuits or open circuits. This may be achieved, for example, by measuring a current provided from a respective power source of the active antenna. If the current exceeds the upper threshold, this indicates a short circuit in the antenna cable. Inversely, if the current drops below a lower threshold value, this may indicate an open circuit or disconnection of the active antenna.

Accordingly, it is an objective of the present invention to describe an integrated circuit device for a satellite receiver and a corresponding satellite receiver system that enables the detection of faults in an antenna connection. Preferably, the proposed solution should allow for a high integration of the receiver circuit and, in particular, avoid the addition of further pins to an IC device.

According to a first aspect of the disclosure, an integrated circuit, IC, device for a satellite receiver is provided. The IC device comprises at least one digital control circuit, a plurality of connection pins, at least two general programmable input/output, GPIO, circuits connected with a first and second connection pin of the plurality of connection pins, respectively, and an antenna monitoring circuit comprising an analog-to-digital converter, ADC, circuit, wherein a signal input of the antenna monitoring circuit is connected to the first connection pin, and a reference input of the antenna monitoring circuit is connected to the second connection pin. The at least one digital control circuit is configured, in a first mode of operation, to selectively provide an analog signal received via the signal input and the reference input to the ADC circuit, to capture a digital value corresponding to the analog signal using the at least one ADC circuit, and to compare the captured digital value with at least one programmable threshold value. In addition, the at least one digital control circuit is further configured, in a second mode of operation, to disconnect at least parts of the ADC circuit from the first and the second connection pin, and capture or provide a respective digital value from or to at least one of the first pin and the second connection pin using the respective GPIO circuit.

By the provision of an antenna monitoring circuit with an integrated ADC circuit, which is configured to be at least partially disconnected from a signal input of the antenna monitoring circuit, external connection pins of an integrated circuit previously used for capturing or providing digital values may be reused to capture an analog signal using the integrated ADC circuit. In this way, the provision of further connection pins for providing an analog input signal to the IC device can be avoided. As a result, the pin count of the IC device is kept low and, in particular, the same as for IC devices without the capability of capturing an analog value, for example a voltage corresponding to a current flowing through a sense resistor connected to an active antenna cable.

Moreover, by integrating the control for the selection of an operating mode and a comparison of a captured digital value with at least one threshold value into the control circuit of the IC device, a more flexible sensing scheme can be enabled, compared with a corresponding sensing circuit implemented in a separate, analog circuit.

According to at least one implementation, the at least two GPIO circuits are configured to be operated in a first voltage domain and at least parts of the ADC circuit are configured to be operated in a second voltage domain, the second voltage domain being lower than the first voltage domain.

For example, a front-end sampling circuit of the ADC circuit may comprise at least one capacitor to electrically decouple the first voltage domain and the second voltage domain. In this case, the front-end sampling circuit may also be used to separate different domains of the IC device, for example a high voltage domain associated with the antenna signal from a low voltage domain associated with the conversion circuit and/or the control circuit.

According to at least one implementation, the front-end sampling circuit may comprise one or more switches selectively disconnecting at least parts of the ADC circuit from the first and second connection pin.

For example, the front-end sampling circuit may comprise a first sampling capacitor, a second sampling capacitor, a first switch connected between the first connection pin and a first terminal of the first sampling capacitor, a second switch connected between the first connection pin and a first terminal of the second sampling capacitor, a third switch connected between the second connection pin and the first terminal of the first sampling capacitor, and a fourth switch connected between the second connection pin and the first terminal of the second sampling capacitor.

Optionally, the ADC circuit may further comprise a conversion circuit, and the front-end sampling circuit may further comprise a first switching arrangement for selectively coupling a second terminal of the first sampling capacitor with a common reference voltage potential, in particular with a common mode voltage, or a first node of the conversion circuit, and a second switching arrangement for selectively coupling a second terminal of the second sampling capacitor with the common reference voltage potential or a second node of the conversion circuit.

Optionally, in the first mode of operation, the at least one digital control circuit is configured to, in a first state, to close the first and fourth switches and to open the second and third switches, while the second terminal of the first sampling capacitor and the second terminal of the second sampling capacitor are connected to the common reference voltage potential, and, in a second state, to close the second and third switches and to open the first and fourth switches, while the second terminal of the first sampling capacitor is connected to the first node of the conversion circuit the second terminal of the second sampling capacitor is connected to the second node of the conversion circuit. In the second mode of operation, the at least one digital control circuit is configured to open at least the first, second, third and fourth switches.

In this way, an electrical decoupling of the ADC circuit from the GPIO circuits can be combined with parts of a front-end sampling circuit of the ADC circuit, reducing the component count of the IC device compared with the use of an additional signal multiplexing circuit.

In at least one embodiment, the at least one ADC circuit is configured as a delta-sigma ADC. In this case, the antenna monitoring circuit may implement the analog circuit components of the delta-sigma ADC, whereas digital processing components of the delta-sigma ADC may be implemented by the at least one digital control circuit of the IC device.

In at least one embodiment, the at least one digital control circuit comprises a comparison unit configured to compare the captured digital value with a first, lower threshold value indicating an open circuit condition and a second, upper threshold value indicating a short circuit condition. By utilizing both a lower and an upper threshold values, different fault conditions can be detected using the same monitoring circuit.

According to a second aspect of the present disclosure, a satellite receiver system is provided. The satellite receiver system comprises at least one active antenna, a power source configured for providing an operating voltage to the active antenna, a sense resistor electrically connected between the power source and the active antenna, and an IC device according to the first aspect, wherein the first connection pin of the IC device is electrically connected to a first terminal of the sense resistor and the second connection pin of the IC device is electrically connected to a second terminal of the sense resistor.

The system according to the second aspect allows the size of a current flowing from the power source towards the at least one active antenna to be sensed, thereby enabling detection of faults of the antenna itself and/or an antenna cable.

According to at least one implementation, in the first mode of operation, the at least one digital control circuit is configured to determine a supply current provided from the power source to the active antenna based on the captured digital value indicative of a voltage drop across the sense resistor and a resistance value of the sense resistor.

According to at least one implementation, the sense resistor and the IC device are provided in a satellite receiver module, in particular on a common printed circuit board, and the at least one active antenna is provided in a separate antenna module connected to the satellite receiver module using an antenna cable. Accordingly, the system may be formed from two prefabricated modules that are connected by a single antenna cable. The satellite receiver module can monitor the cable connection between the two modules based on the sense resistor and the IC device.

According to at least one implementation, the satellite receiver module further comprises an antenna switch connected between the power source and the antenna cable, and the IC device further comprises a third GPIO circuit connected to a control terminal of the antenna switch. The at least one digital control circuit is further configured to open the antenna switch to disconnect the power source from the antenna cable, when the captured digital value exceeds an upper threshold value. In this way, damage to a power source can be avoided, for example in case of a short circuit in the antenna cable.

According to at least one implementation, the power source, and the antenna switch are provided externally to the IC device, and the third GPIO circuit is connected via a third connection pin of the plurality of connection pins to the antenna switch.

According to an alternative implementation, the power source, the antenna switch and the third GPIO circuit are integrated into the IC device.

According to at least one implementation, the satellite receiver module further comprises a direct current, DC, blocking element, in particular a capacitor, and an alternating current, AC, blocking element, in particular an inductor. The IC device further comprises a radio frequency, RF, input circuit connected to the antenna cable via the DC blocking element, and the AC blocking element is electrically connected between the antenna cable and the sense resistor. In this way, DC and AC signal components can be provided separately to the respective parts of the IC device.

According to at least one implementation, the satellite receiver module further comprises a first voltage divider and a second voltage divider. The first voltage divider comprises a first pull-up resistor, connected between the first terminal of the sense resistor and the first connection pin, and a first pull-down resistor, connected between a reference potential, in particular electrical ground, and the first connection pin. The second voltage divider comprises a second pull-up resistor, connected between the second terminal of the sense resistor and the second connection pin, and a second pull-down resistor, connected between the reference potential and the second connection pin. In this way, high external voltages can be reduced to protect the IC device.

Further details of the disclosed devices and systems are provided in the attached set of claims as well as the following, detailed description of embodiments.

Different embodiments of the invention are described with respect to the attached drawings.
Figure 1 shows a satellite receiver system according to an embodiment of the present disclosure.
Figure 2 shows a schematic diagram of pathways in an IC device for a satellite receiver system.
Figure 3 shows a circuit diagram of an antenna monitoring circuit integrated into an IC device.

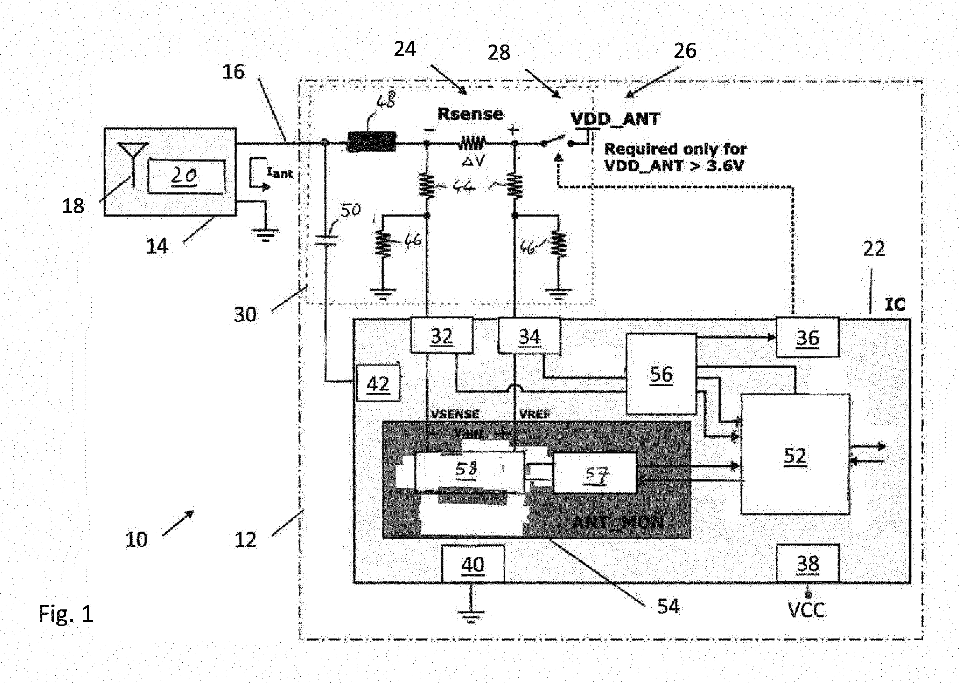

Figure 1 shows, in a schematic manner, a satellite receiver system 10 comprising a satellite receiver module 12 and an antenna module 14. The satellite receiver module 12 and antenna module 14 are connected by an antenna cable 16. The antenna cable 16 carries a radio frequency (RF) signal provided by the antenna module 14 to the satellite receiver module 12. At the same time, a direct current (DC) Iₐₙₜ flows from the satellite receiver module 12 to the antenna module 14 to provide the antenna module 14 with an operating current. For example, the antenna module 14 may comprise an antenna element 18 and a low noise amplifier (LNA) 20 and may be grounded to allow the direct current Iₐₙₜ to flow from the antenna module 14 to electrical ground or a reference potential.

In the described embodiment, the satellite receiver module 12 comprises a satellite receiver chip 22 in the form of an integrated circuit (IC). The satellite receiver module 12 further comprises a sense resistor 24, a power source 26, and an antenna switch 28, for example a MOSFET. Electrical nodes between the antenna switch 28 and a first terminal of the sense resistor 24 and between a second terminal of the sense resistor 24 and the antenna cable 16 are connected, by means of a connection circuit 30, to a first connection pin 32 and a second connection pin 34 of the satellite receiver chip 22. Moreover, the antenna switch 28 is connected to a third connection pin 36 of the satellite receiver chip 22, which controls the antenna switch 28.

The satellite receiver chip 22 may have further connection pins, such as connection pins 38 and 40 for the provision of a supply voltage Vcc and a reference potential, such as electrical ground.

In the described embodiment, the connection circuit 30 further comprises a capacitor 50 for capacitively coupling the antenna cable 16 to an RF input pin 42 of the satellite receiver chip 22. Note that the capacitor 50 blocks the antenna supply voltage VDD_ANT from reaching the RF input pin 42. Moreover, the connection circuit 30 comprises an inductor 48 for blocking the radio frequency signal received from the antenna module 14 from reaching the connection pins 32 to 36.

In the specific embodiment shown in Figure 1, the connection circuit 30 comprises two pull-up resistors 44 and two pull-down resistors 46 for reducing a supply voltage VDD_ANT of the power source 26 to a voltage level acceptable to the satellite receiver chip 22. Note that these resistors are only necessary in case the supply voltage VDD_ANT for the antenna exceeds the operating voltage of the chip 22, e.g. 3.6 V, and may be otherwise omitted.

In operation, the active antenna module 14 may be activated by closing the antenna switch 28 under the control of a controller 52 of the satellite receiver chip 22. The controller 52 may be a multi-purpose microcontroller circuit responsible for implementing various control algorithms of the satellite receiver chip 22 or may be a logical control unit or software routine responsible only for the control of the external antenna module 14. Accordingly, the antenna current Iₐₙₜ will start to flow from the power source 26 via the sense resistor 24 and the inductor 48 to the LNA 20 of the antenna module 14. A voltage ΔV will drop across the sense resistor 24, which is proportional to the current flowing from the satellite receiver module 12 towards the antenna module 14. In the case that the antenna cable 16 is damaged, for example separated or short-circuited, the current provided from the power source 26 will drop below or exceed a normal supply level. This in turn will result in a corresponding reduced or increased voltage drop across the sense resistor 24.

The satellite receiver chip 22 comprises an antenna monitoring circuit 54 for detection of faults of the active antenna 14 and/or the antenna cable 16. In practice, this is achieved by sensing a voltage drop ΔV across the sense resistor 24 and comparing it with one or more threshold values. On the conceptual level shown in Fig. 1, the antenna monitoring circuit 54 translates a corresponding analog voltage difference V_{diff} = V_{SENSE} - V_{REF} at the first and second connection pins 32 and 34 using an ADC circuit 58 into the digital domain. As discussed in more detail below, the ADC circuit 58 may be a delta-sigma ADC and comprise, for example, an analog circuit part, implementing a delta-sigma modulator, and a digital circuit part, implementing a delta-sigma decimation filter. A comparison unit 57 then compares the received digital value with a corresponding threshold value provided by the controller 52 and provides a corresponding digital status signal indicating the result of the comparison back to the controller 52. As the comparison unit 57 operates in the digital domain, the threshold value may be stored in a memory cell or register of the chip 22. Accordingly, more than one threshold value may be easily provided and modified in accordance with the specific configuration of the satellite receiver module 12 and/or the antenna module 14. For example, a first, lower threshold for the voltage difference V_{diff} may be used to detect an open circuit condition indicating, for example, a disconnection of the antenna module 14 or the antenna cable 16. A second, upper threshold for the voltage difference V_{diff} may be used to detect a short circuit condition indicating, for example, a damaged antenna module 14 or antenna cable 16.

Attention is drawn to the fact that the first and second connection pins 32 and 34, as well as the third connection pin 36, are also connected to respective GPIO circuits (not shown) or channels of a multi-channel GPIO controller 56 of the satellite receiver chip 22. Note that, in practice, integrated circuits often provide a number of freely programmable input output circuits or channels, which can be controlled by an integrated controller, such as the controller 52. According to the disclosed embodiment, the connection pins 32 to 36 correspond to respective channels of the multichannel GPIO controller 56.

In the case that the antenna monitoring circuit 54 is not used, the GPIO controller 56 may provide two separate digital output signals via the first connection pin 32 and the second connection pin 34, respectively. Alternatively, the GPIO controller 56 may also receive up to two digital input signals via the first connection pin 32 and/or the second connection pin 34, respectively. However, in the case that the satellite receiver chip 22 wants to measure the current flowing from the satellite receiver module 12 to the antenna module 14, the first connection pin 32 and the second connection pin 34 are connected to the antenna monitoring circuit 54 to sense the analog voltage difference between to the first connection pin 32 and the second connection pin 34.

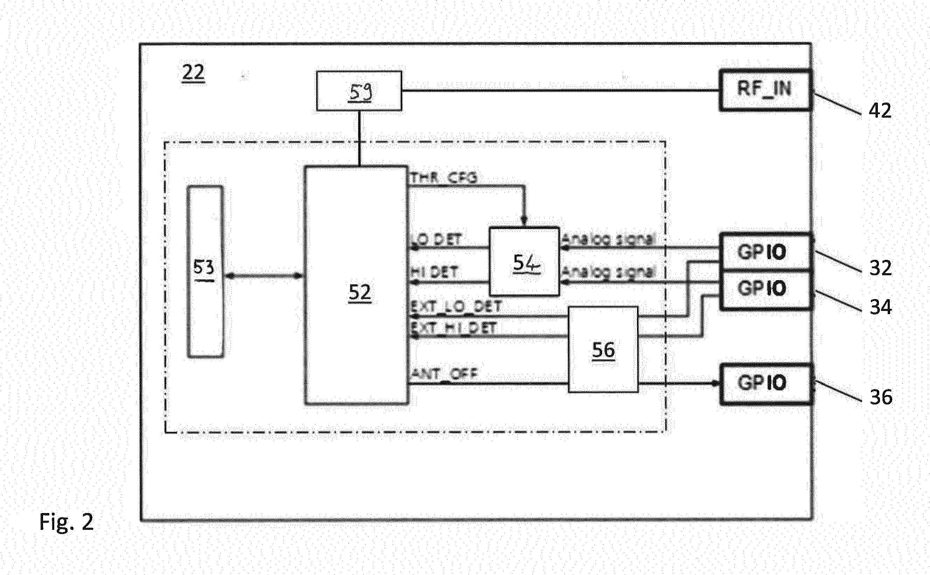

Figure 2 shows this conceptual connection arrangement. Note that the first and second connection pins 32 and 34 are connected to the controller 52 by two different pathways. A first pathway via the GPIO controller 56 is provided for the provision or reception of digital control signals EXT_LO_DET and/or EXT_HI_DET. A second pathway via the ADC circuit 58 is provided for the acquisition of an analog signal in the form of a voltage difference. This analog signal is monitored by the antenna monitoring circuit 54. In the embodiment shown in Fig. 2, antenna monitoring circuit 54 compares the a voltage drop across the first and second connection pins 32 and 34 with a digital reference value THR_CFG provided by the controller 52 and then, based on the result of the comparison, provides either a low or high digital signal LO_DET or HI_DET to the controller 52 to indicate whether a respective threshold was exceed or not. The third connection pin 36 is configured as an output channel and provides the digital control signal ANT_OFF to control the provision of the supply voltage for the antenna module 14.

Figure 2 also shows a signal path for the actual satellite signal from the RF input pin 42 via an RF input circuit 59 to the controller 52. In the depicted embodiment, the controller 52 is also connected with other components of the satellite receiver chip 22 by means of a digital control bus 53. By means of the control bus 53, registers of the controller 52 and other components can be read out and set.

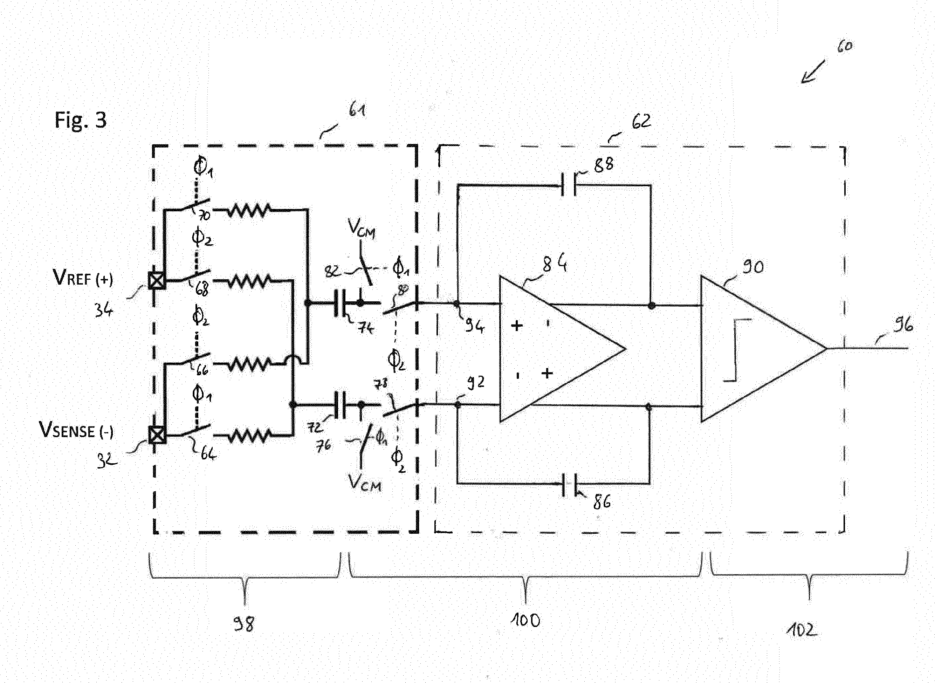

In the described embodiment, the ADC circuit 58 is implemented as a delta-sigma ADC. Figure 3 shows an analog circuit 60 of the delta-sigma modulator, in particular an analog circuit part of a delta-sigma modulator, in more detail. As shown, the analog circuit 60 comprises a front-end sampling circuit 61, and a conversion circuit 62. In the described embodiment, the front-end sampling circuit 61 is controlled by the provision of respective control signals Φ₁ and Φ₂, generated by the conversion circuit 62 and/or the controller 52 to successively perform the analog to digital conversion.

The front-end sampling circuit 61 selectively couples the sense signal V_{SENSE} received from the first connection pin 32 and the reference signal V_{REF} received from the second connection pin 34 of the antenna monitoring circuit 54 with the further components of the conversion circuit 62. It comprises four switches 64, 66, 68 and 70, which selectively provides the voltages provided via the connection pins 32 and 34 to first terminals of two sampling capacitors 72 and 74. The front-end sampling circuit 61 further comprises four further switches 76, 78, 80 and 82, which selectively connect second terminals of the two sampling capacitors 72 and 74 wither with a reference potential, in particular a common mode voltage V_{cm}, or corresponding nodes 92 and 94 of the conversion circuit 62. The switches 64 to 70 and 76 to 82 may be MOSFETs or similar semiconductor switching elements. The common mode voltage V_{cm} may be generated using a simple resistor divider circuit (not shown). Optionally the resistor divider circuit may be disabled, e.g. using a NMOS on its GND side, to disable a corresponding current, when the common mode voltage V_{cm} is not required.

In operation, the front-end sampling circuit 61 switches between a first state and a second state with a first switching frequency *f₁*. In the first state a first control signal Φ₁ is provided and the switches 64, 70, 76 and 82 are closed, such that the first sampling capacitor 72 is charged to a voltage difference between the sense signal V_{SENSE} and the common mode voltage V_{cm}, and the second sampling capacitor 74 is charged to a voltage difference between the reference signal V_{REF} and the common mode voltage V_{cm}. All other switches remain open. In the second state a second control signal Φ₂ is provided and all switches are inverted such that the first and second capacitors 72 and 74 are connected via the first and second nodes 92 and 94, respectively, to an operational amplifier 84 of the conversion circuit 62. The positive and negative output signals from the operational amplifier 84 are fed back via two integration capacitors 86 and 88 to the first node 92 and the second node 94 at the negative and positive input terminals of the operational amplifier 84, respectively.

In the described embodiment, the input and output signals to and from the operational amplifier 84 are optionally chopped using corresponding chopping switches (not shown) at a second, switching frequency *f₂*. The second, switching frequency *f₂* is lower than the first switching frequency *f₁*, for example *f₂ = 1*/*8 f₁.* Accordingly, the operational amplifier 84 is operated in a first orientation for a few cycles of the first and second states. Thereafter, the operational amplifier 84 is flipped upside down and is operated in a second orientation for a few cycles of the first and second states. This enables to move any input offset to a high frequency domain. The offset can then be easily removed by a decimation filter arranged downstream of the analog circuit shown in Figure 3. Attention is drawn to the fact that described circuit could be operated without the chopping switches and corresponding control signals, if no or only a limited offset is present in the input signal, or the subsequent circuits can otherwise deal with an offset.

The output signal provided by the operational amplifier 84 is also provided to a comparator 90. Depending on the result of the comparison by the comparator 90, charge is either is injected into the second node 94 and removed from the first node 92 using corresponding delta-sigma-feedback loops (not shown). That means that charge is injected into the second terminal of the sampling capacitor 74 and removed from the second terminal of the sampling capacitor 72 using corresponding capacitors and drivers (not shown), or vice versa, based on the output signal of the comparator 90. As a result, the charge on the feedback capacitors 86 and 88 is regulated continuously towards a fixed value, and the analog circuit 60 acts as a first-order delta-sigma modulator. At the same time, the comparator 90 provides a modulation output in the form of a digital, PCM output signal 96, which is fed to the digital part of the delta-sigma ADC to determine if charge is added or removed. This allows the delta-sigma ADC to determine the long term or low-frequency behavior of the analog voltage difference V_{diff} provided at the input of the antenna monitoring circuit 54. For this purpose, the delta-sigma ADC further comprises a timer-based digital filter and/or a designator component, i.e. the decimator filter of the delta-sigma converter (not shown in Figure 3).

Attention is drawn to the fact that the analog circuit 60 shown in Figure 3 crosses three different voltage and signal domains. In particular, the input side of the front-end sampling circuit 61 operates in an analog, first voltage domain 98, for example in the range of up to 3.6 V corresponding to the signals provided by the connection circuit 30. The sampling capacitors 72 and 74 effectively decouple the first voltage domain 98 from a second, in the example lower, voltage domain 100 comprising the operational amplifier 84, the integrating capacitors 86 and 88 as well as the inputs of the comparator 90. Lastly, the comparator 90 separates the analog, second voltage domain 100 from a digital signal domain 102 of the ADC circuit 58 and/or the controller 52. While the connection pins 32 to 36 and corresponding circuit components of the satellite receiver chip 22 are configured for a specific input voltage, requiring the previously mentioned voltage divider in case of higher input voltages, the operational amplifier 84 and other electronic components within the conversion circuit 62 and other part of the satellite receiver chip 22 may work with one or more different supply voltages, lower than the specific input voltage.

Note that the front-end sampling circuit 61 can also be used to completely decouple most of the components of the antenna monitoring circuit 54, including the entire conversion circuit 62 of the ADC circuit 58 in the second voltage domain 100, from the connection pins 32 and 34 and the GPIO controller 56 by simply opening all of the switches 64, 66, 68 and 70. Accordingly, no further components are necessary to switch the satellite receiver circuit 22 from a first mode of operation, wherein the first connection pin 32 and the second connection pin 34 are used to capture an analog input signal, to a second operating mode, wherein the first connection pin 32 and the second connection pin 34 are used as normal GPIO pins.

Accordingly, the disclosed circuits and devices allow the connection pins 32 and 34 to be multiplexed for implementing different functionalities. Specifically, the disclosed antenna monitoring circuit 54 enables the controller 52 to monitor the voltage drop at the sense resistor 24 using pins already provided in a conventional chip designs for a satellite receiver circuit.

### List of reference symbols

- 10: satellite receiver system
- 12: satellite receiver module
- 14: antenna module
- 16: antenna cable
- 18: antenna
- 20: low noise amplifier (LNA)
- 22: satellite receiver chip
- 24: sense resistor
- 26: power source
- 28: antenna switch
- 30: connection circuit
- 32: first connection pin
- 34: second connection pin
- 36: third connection pin
- 38: voltage pin
- 40: ground pin
- 42: radio frequency (RF) input pin
- 44: pull-up resistor
- 46: pull-down resistor
- 48: inductor
- 50: capacitor
- 52: controller
- 53: digital control bus
- 54: antenna monitoring circuit
- 56: GPIO controller
- 57: comparison unit
- 58: ADC circuit
- 59: RF input circuit
- 60: analog circuit
- 61: front-end sampling circuit
- 62: conversion circuit
- 64 to 70: switches
- 72, 74: sampling capacitor
- 76 to 82: switches
- 84: operational amplifier
- 86, 88: integration capacitor
- 90: comparator
- 92: first node
- 94: second node
- 96: PCM output signal
- 98: first voltage domain
- 100: second voltage domain
- 102: digital signal domain

## Claims

1. An integrated circuit, IC, device for a satellite receiver, comprising:
- at least one digital control circuit;
- a plurality of connection pins (32, 34, 36);
- at least two general programmable input/output, GPIO, circuits connected with a first (32) and second connection pin (34) of the plurality of connection pins (32, 34, 36), respectively; and
- an antenna monitoring circuit (54) comprising an analog-to-digital converter, ADC, circuit (58), wherein a signal input of the antenna monitoring circuit (54) is connected to the first connection pin (32), and a reference input of the antenna monitoring circuit (54) is connected to the second connection pin (34);
- wherein the at least one digital control circuit is configured, in a first mode of operation:
- to selectively provide an analog signal received via the signal input and the reference input to the ADC circuit (58) ;
- to capture a digital value corresponding to the analog signal using the at least one ADC circuit (58); and
- to compare the captured digital value with at least one programmable threshold value; and
- wherein the at least one digital control circuit is further configured, in a second mode of operation:
- to disconnect at least parts of the ADC circuit (58) from the first and the second connection pin (32, 34); and
- to capture or provide a respective digital value from or to at least one of the first pin (32) and the second connection pin (34) using the respective GPIO circuit.

2. The IC device of claim 1, wherein
- the at least two GPIO circuits are configured to be operated in a first voltage domain (98); and
- at least parts of the ADC circuit (58) are configured to be operated in a second voltage domain (100), the second voltage domain being lower than the first voltage domain (98) .

3. The IC device of claim 2, wherein the ADC circuit (58) comprises a front-end sampling circuit (61), the front-end sampling circuit (61) comprising at least one capacitor (72, 74) configured to electrically decouple the first voltage domain (98) and the second voltage domain (100).

4. The IC device of claim 3, wherein the front-end sampling circuit (61) comprises:
- a first sampling capacitor (72);
- a second sampling capacitor (74);
- a first switch (64) connected between the first connection pin (32) and a first terminal of the first sampling capacitor (72);
- a second switch (66) connected between the first connection pin (32) and a first terminal of the second sampling capacitor (74);
- a third switch (68) connected between the second connection pin (34) and the first terminal of the first sampling capacitor (72); and
- a fourth switch (70) connected between the second connection pin (34) and the first terminal of the second sampling capacitor (74).

5. The IC device of claim 4, wherein the ADC circuit (58) further comprises a conversion circuit (62), and the front-end sampling circuit (61) further comprises:
- a first switching arrangement for selectively coupling a second terminal of the first sampling capacitor (72) with a common reference voltage potential, in particular with a common mode voltage, or a first node (92) of the conversion circuit (62); and
- a second switching arrangement for selectively coupling a second terminal of the second sampling capacitor (74) with the common reference voltage potential or a second node (94) of the conversion circuit (62).

6. The IC device of claim 5, wherein
- in the first mode of operation, the at least one digital control circuit is configured to,
- in a first state, to close the first and fourth switches (64, 70) and to open the second and third switches (66, 68), while the second terminal of the first sampling capacitor (72) and the second terminal of the second sampling capacitor (74) are connected to the common reference voltage potential,
- in a second state, to close the second and third switches (66, 68) and to open the first and fourth switches (64, 70), while the second terminal of the first sampling capacitor (72) is connected to the first node (92) of the conversion circuit (62) the second terminal of the second sampling capacitor (74) is connected to the second node (94) of the conversion circuit (62); and
- in the second mode of operation, the at least one digital control circuit is configured to open at least the first, second, third and fourth switches (64, 66, 68, 70).

7. The IC device of any one of claims 1 to 6, wherein the at least one ADC circuit (58) is configured as a delta-sigma ADC.

8. The IC device of any one of claims 1 to 7, the at least one digital control circuit comprises a comparison unit (57) configured to compare the captured digital value with a first, lower threshold value indicating an open circuit condition and a second, upper threshold value indicating an short circuit condition.

9. A satellite receiver system (10), comprising:
- at least one active antenna;
- a power source (26) configured for provided an operating voltage to the active antenna;
- a sense resistor (24) electrically connected between the power source (26) and the active antenna; and
- the IC device according to any one of claims 1 to 8, wherein the first connection pin (32) of the IC device is electrically connected to a first terminal of the sense resistor (24) and the second connection pin (34) of the IC device is electrically connected to a second terminal of the sense resistor (24).

10. The satellite receiver system (10) of claim 9, wherein, in the first mode of operation, the at least one digital control circuit is configured to determine a supply current provided from the power source (26) to the active antenna based on the captured digital value indicative of a voltage drop across the sense resistor (24) and a resistance value of the sense resistor (24).

11. The satellite receiver system (10) of claim 9 or 10, wherein:
- the sense resistor (24) and the IC device are provided in a satellite receiver module (12), in particular on a common printed circuit board; and
- the at least one active antenna is provided in a separate antenna module (14) connected to the satellite receiver module (12) using an antenna cable (16).

12. The satellite receiver system (10) of claim 11, wherein:
- the satellite receiver module (12) further comprises an antenna switch (28) connected between the power source (26) and the antenna cable (16);
- the IC device further comprises a third GPIO circuit connected to a control terminal of the antenna switch (28); and
- the at least one digital control circuit is further configured to open the antenna switch (28) to disconnect the power source (26) from the antenna cable (16), when the captured digital value exceeds an upper threshold value.

13. The satellite receiver system (10) of claim 12, wherein
- the power source (26), and the antenna switch (28) are provided externally to the IC device, and the third GPIO circuit is connected via a third connection pin (36) of the plurality of connection pins (32, 34, 36) to the antenna switch (28); or
- the power source (26), the antenna switch (28) and the third GPIO circuit are integrated into the IC device.

14. The satellite receiver system of any one of claims 9 to 13, wherein
- the satellite receiver module (12) further comprises a direct current, DC, blocking element, in particular a capacitor (50), and an alternating current, AC, blocking element, in particular an inductor (48);
- the IC device further comprises a radio frequency, RF, input circuit (59) connected to the antenna cable (16) via the DC blocking element; and
- the AC blocking element is electrically connected between the antenna cable (16) and the sense resistor (24).

15. The satellite receiver system (10) of any one of claims 9 to 14, wherein:
- the satellite receiver module (12) further comprises a first voltage divider and a second voltage divider;
- the first voltage divider comprises a first pull-up resistor (44), connected between the first terminal of the sense resistor (24) and the first connection pin (32), and a first pull-down resistor (46), connected between a reference potential, in particular electrical ground, and the first connection pin (32); and
- the second voltage divider comprises a second pull-up resistor (44), connected between the second terminal of the sense resistor (24) and the second connection pin (34), and a second pull-down resistor (46), connected between the reference potential and the second connection pin (34).
